Europäisches Patentamt

European Patent Office

Office européen des brevets

(19)

(11) Publication number: **0 186 818 B1**

(12) **EUROPEAN PATENT SPECIFICATION**

(45) Date of publication of patent specification: **06.03.91**  (51) Int. Cl.⁵: **H01L 23/48**

(21) Application number: **85115710.7**

(22) Date of filing: **10.12.85**

(54) Chip to pin interconnect method.

(30) Priority: **31.12.84 US 687696**

(43) Date of publication of application:
**09.07.86 Bulletin 86/28**

(45) Publication of the grant of the patent:
**06.03.91 Bulletin 91/10**

(84) Designated Contracting States:
**DE FR GB**

(56) References cited:
**US-A- 3 868 724**
**US-A- 3 931 922**
**US-A- 4 045 863**

**IBM TECHNICAL DISCLOSURE BULLETIN, vol.
26, no. 3A, August 1983, pages 927-928; H.C.
JONES et al.: "Plug and socket chip joining"**

(73) Proprietor: **International Business Machines
Corporation
Old Orchard Road
Armonk, N.Y. 10504(US)**

(72) Inventor: **Marks, Robert
17 Scottsdale Road
South Burlington Vermont 05401(US)**
Inventor: **Phelps, Douglas Wallace, Jr.
21 Richardson Street
Burlington Vermont 05401(US)**
Inventor: **Ward, William Carroll
28 Bilodeau Ct.
Burlington Vermont 05401(US)**

(74) Representative: **Klocke, Peter, Dipl.-Ing.
IBM Deutschland GmbH Patentwesen und
Urheberrecht Schönaicher Strasse 220
W-7030 Böblingen(DE)**

**Description**

This invention relates to an integrated circuit package in accordance with claim 1 and a method of its manufacture.

Packaging of semiconductor devices have followed two separate and distinct paths. One utilizes the connection of the chip to rigid substrate structures such as is shown in U.S. Patent 3,871,015 to Paul T. C. Lin et al. The other utilizes sets of leads fabricated on the surface of a flexible insulative tape with the chip beam bonded thereto by means of wire leads with the entire unit encapsulated in a plastic member. Such a structure is shown in U.S. Patent 4,157,611.

Attempts to improve this latter structure and avoid this wire bonding of leads has also been attempted as typified by U.S. Patent 3,868,724 wherein the leads mounted on the insulative tape have been provided with contact nodes that penetrate the tape through holes formed therein. These holes are in a predetermined pattern so that the contact nodes are formed in the holes and extend there through to provide an ohmic contact between the conductors and integrated circuit chips aligned with the contact nodes and bonded thereto. Ultimately, an encapsulation is formed around the entire chip and selected portions of the tape for completely housing the chip.

This technique requires careful and critical alignment of the semiconductor chip to the contact nodes and when the contacts on the chip are asymmetrical inaccurate bonding could result.

It is therefore the object of the present invention to provide an improved integrated circuit package of the aforementioned kind and a method for its manufacture. This object is achieved by the invention as described in claims 1 and 2; embodiments of the invention are characterized in the subclaims.

The novel connecting structure for semiconductor devices uses an insulating film having conductive leads formed on a first surface thereof. A plurality of sets of holes are formed, in a predetermined pattern, in the film so as to expose the tips of the underlying conductors which are exposed so that an ohmic connection can be made to each of the conductors when a semiconductor chip having a plurality of surface input/output contacts such as solder balls thereon is aligned with the hole pattern provided in the insulating layer and subsequently bonded thereto. An encapsulation is then formed around the chip and adjacent portions of the insulating film for completely housing the chip therein while still providing external conductors extending beyond the encapsulation for connection to external circuitry.

This present invention has a number of advantages over the prior art in that superior electrical and thermal performance relative to wire bonding is achieved. Furthermore, this invention provides a package with a low profile structure and can be extended to high density stackable, two-sided tapes and assemblies. Also the present invention needs but a simplified bonding technique and is a very low cost product. Finally the invention assures that the chip is always properly aligned.

These and other advantages of the present invention will become apparent from the detailed description of the following preferred embodiment when taken with the following figure wherein;

Fig. 1 is a partial isometric view of an insulated lead frame made in accordance with the present invention, and

Fig. 2 shows a partial cross-sectional view of the insulated packaging strip of the invention taken generally along the lines 2-2 of Fig. 1 and with a semiconductor device bonded thereto.

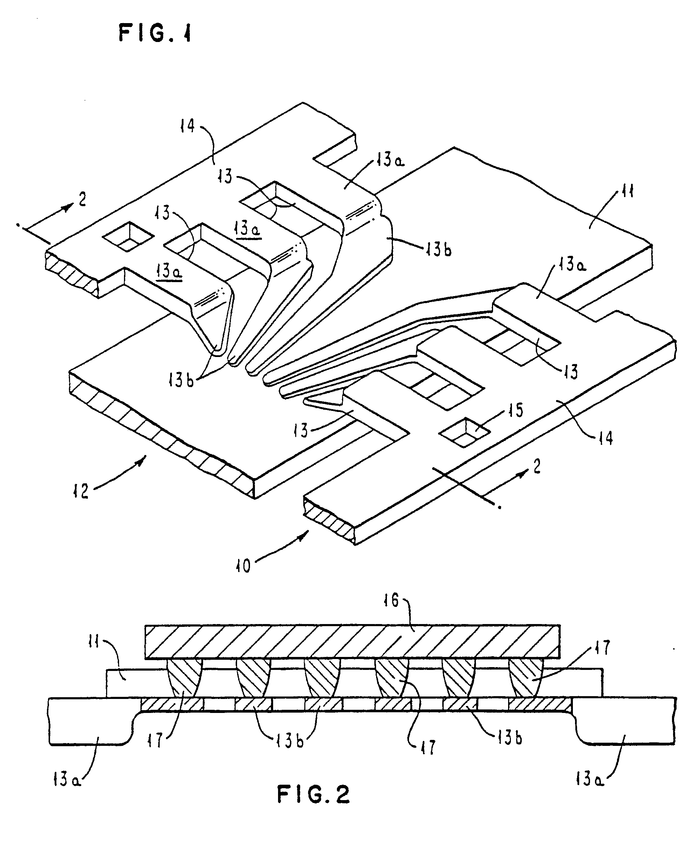

Shown in Figs. 1 and 2 are partial sectional views of a sprocket driven semiconductor packaging lead frame 10 made in accordance with the present invention.

Generally the lead frame 10 comprises a lamination composed of an insulating film 11 affixed to a formed metal pattern 12. The metal pattern 12 is formed from a solid copper or copper alloy 88,9 $\mu$m (0.0035 inch) thick strip having an insulating film 11 formed thereon. The insulating film 11 generally consists of a 12,7 to 45,7 $\mu$m (0.0005 to 0.0018 inch) thick film of polyimide.

Other suitable insulating materials, besides the described polyimide, can be used provided they can be treated in accordance with the invention as set forth below and exhibit the proper durability, flexibility and compatibility with the semiconductor processing procedures to be used.

The preferred method of creating this lead frame 10 is as follows. A strip of copper, having parallel planar sides from 152,5 to 254 $\mu$m (0.006 to 0.010 inches) in thickness, of suitable width and having sprocket hole 15 formed therein is selected and its center portion is thinned, by any suitable technique, such as rolling, etching or stamping, down to 33 $\mu$m (0.0013 inches) in thickness. As shown in the figures, only the upper surface of the strip is thinned and the lower surface remains in its initial plane.

Once the strip is thinned a film of polyimide is formed on its bottom untreated surface, i.e. the bottom planar surface of the copper strip. This polyimide film is preferably from 12,7 to 45,7 $\mu$m (0.0005 to 0.0018 inches) in thickness and may be formed in situ by any suitable method such as casting, flowing on a liquid polyimide or the like.

Once the film of polyimide is laid down on the copper strip the copper strip is photolithographically etched to form the selected metallic pattern 12.

Specifically the formed metallic pattern 12 is composed of a plurality of metallic fingers or leads 13 joined to parallel selvage strips 14. Each finger or lead 13 is formed of a relatively thick portion 13a about 152,4 to 254 μm (.006 inches to .010 inches) in thickness and substantially thinner section 13b about 33 μm (0.0013 inches) in thickness. As shown the thinned portions 13b overlie the polyimide film 11 and are formed from the previously thinned central section of the copper strip.

It should be noted that the polyimide film 11 must be of sufficient width and length so as to extend beyond all edges of the chip to be placed thereon. This film not only insulates the chip electrically but also serves to protect the chip from radiation such as alpha particles.

It should also be noted that the thinned sections 13b of each lead provides easier bonding to the chip as well as stress relief.

The plurality of equispaced sprocket holes 15 in each selvage strip 14 are employed for indexing the lead frame 10 through the various stages of fabrication and process steps required both for forming the lead frame of the present invention and for bonding integrated circuit chips to the lead frame 10.

Once the desired pattern 12 has been formed on the insulating film 11, a series of holes, in accordance with the present invention are etched in the polyimide film 11. A suitable process for etching these holes is described in U.S. Patent 4,353,778 to J. P. Fineman et al, incorporated herein by reference. These openings as shown in Fig. 2 are formed in a pattern over the tip of each thinned lead 13b. This pattern is made to match the input/output contacts set out on the pattern of the chip to be joined to the unit. This input/output pattern, also known as the chip footprint, can be derived directly from the design criteria used for creating the chip surface connection on the chip itself.

Once these openings are suitably formed in the polyimide, the chip can be joined to the lead frame 10. If desired a thin coating of tin can be deposited in the holes in the polyimide and on the exposed tips of the leads 13b to assure a better, lower temperature bond to the input/output connections on the chip. Of course it must be understood that if such a tin layer is used that it cannot be of any appreciable thickness and must be thin enough such the formed holes in the polyimide retain a depth sufficient to permit the holes to continue to serve to align the input/output connections of the chip placed thereon.

In the preferred embodiment, a semiconductor chip 16 previously dimensioned and provided with a plurality of electrical input/output contacts 17, such as solder balls, arranged in a desired pattern or footprint, is placed on the lead frame such that the contacts 17 are seated in the holes formed in the polyimide and contact the underlying leads 13b.

The contacts or solder balls 17 which are formed on the semiconductor chip 16 are well known in the art and typified in U.S. Patent 3,392,442 to J. Napier et al. These contacts 17 typically comprise a body of lead-tin alloy mounted on suitable electrical nodes formed on the surface of the semiconductor chip 16 which contacts 17 serve as input or output connections to the underlying electrical devices formed in the chip 16.

Once the integrated chip having contacts 17 arranged in a pattern or footprint corresponding to the openings in the polyimide film is positioned over and matched to the footprint previously opened or formed in the polyimide layer. The integrated circuit chip is self aligned to the underlying leads 13b and is then bonded to the exposed tips of the leads 13b by any suitable bonding technique, such as a heating element, for example a thermode brought into contact with the lead frame or by placing the entire unit in a suitable furnace or other heating medium. Once the solder balls on the chip are suitably bonded to the lead frame an encapsulation structure is formed around the circuit. Such encapsulation structures can be of plastic as in the well known dual inline package (DIP) or can be formed of glass or ceramic. Finally, the encapsulated circuit chips and the extended fingers 13 are cut away from the selvage 14 and tested.

There has been described an integrated circuit package including a flexible insulated lead frame and a flip chip having a plurality of input/output solder balls in predetermined positions thereon. The lead frame is provided with a plurality of flexible metallic leads on an insulation coating. A plurality of openings is etched in the insulating coating over the ends of the leads to be connected to the contacts on the chip. These openings in the insulation are in the same pattern as the balls on the chip and act to assure that the chip is properly positioned on the lead frame and that the solder balls are contained in a restricted area and provide significant electrical contact to the exposed lead frames.

It should now be obvious to those skilled in the art that various modifications can be made to the present invention. For example, the fingers 13 could be of sufficient length such they extend beyond the encapsulation and act as external leads or alternately could be joined for example by welding, to external leads.

## Claims

1. An integrated circuit package with
flip chip (16) having a plurality of vertically extended input/output contacts (17) in predetermined positions mounted thereon,
a plurality of flexible metallic leads (13) disposed on an insulating film (11),
a plurality of openings in the insulating film (11) adjacent the ends of the leads (13) to expose the leads to the input/output contacts (17) on the chip,
the openings in the insulation (11) being in the same pattern as the contacts (17) on the chip so as to act as a socket to assure that the chip is properly positioned and aligned on the leads, that each of the contacts are contained in the openings to provide electrical contact to the exposed leads, and that the length and width of the insulation extends beyond all edges of the chip, and encapsulation means surrounding the chip and the leads in the film,
characterized in that
the leads (13) have a reduced thickness in their part overlying the pattern of holes in the insulating film (11).

2. Method of manufacturing an integrated circuit package comprising the steps of:
forming electrical conductors (13) on a first surface of a film (11) of insulating material, by thinning the middle portion of a stripe of conducting material, applying a film of said insulating material to the flat bottom surface of the stripe of conducting material, and defining the electrical conductors by photolithographic means from the stripe of conducting material, maintaining a selvage portion (10),
forming a plurality of holes in a predetermined pattern in the insulating material wherein portions of said conductors are exposed through the holes, and
placing a semiconductor chip (16) with a plurality of input and output contacts (17), having a pattern identical to that of the formed holes in the insulating material on the film,
each contact being in registry with a corresponding hole and extending from the surface of the semiconductor chip to the underlying conductor through the film while the remainder of the semiconductor chip is electrically insulated from the electrical conductors by the insulating film,
electrically bonding the contacts (17) of the chip to the electrical conductors (13) in the holes,
placing an encapsulation means around the chip and the conductors formed on the insulating film.

3. The method of claim 2, characterized in that the encapsulation step comprises:
severing the selvage portion from the encapsulated chip.

## Revendications

1. Support-boîtier à circuit intégré, comprenant
une pastille à protubérances (16) possédant une pluralité de contacts d'entrée/sortie (17) montés à des positions prédéterminées sur la pastille et faisant perpendiculairement saillie d'elle,
une pluralité de connexions métalliques flexibles (13) disposées sur un film isolant (11),
une pluralité d'ouvertures pratiquées dans le film isolant (11) à proximité des bouts des connexions (13) pour exposer les connexions aux contacts d'entrée/sortie (17) sur la pastille,
les ouvertures du film isolant (11) ayant le même motif que les contacts (17) sur la pastille, de sorte qu'elles agissent à la façon d'une douille pour assurer que la pastille soit convenablement positionnée et alignée sur les connexions, que chacun des contacts soit contenu dans une ouverture en vue de la réalisation d'un contact électrique avec la connexion exposée correspondante, et que la longueur et la largeur du film isolant s'étendent au-delà de tous les bords de la pastille, et
un moyen d'encapsulation entourant la pastille et les connexions sur le film,
caractérisé en ce que
les connexions (13) ont une épaisseur réduite dans leur partie disposée par-dessus le motif d'ouvertures du film isolant (11).

2. Procédé pour fabriquer un support-boîtier à circuit intégré, comprenant les étapes consistant à:
former des conducteurs électriques (13) sur une première face d'un film (11) de matériau isolant, par amincissement de la partie médiane d'une bande de matériau conducteur, application d'un film dudit matériau isolant sur la face inférieure plane de la bande de matériau conducteur et définition des conducteurs électriques par des moyens photolithographiques à partir de la bande de matériau conducteur, avec préservation d'une partie (14) formant bordure,

former une pluralité de trous suivant un motif prédéterminé dans le matériau isolant, de manière que des parties des conducteurs soient exposées à travers les trous, et placer sur le film une pastille semi-conductrice (16) possédant une pluralité de contacts d'entrée et de sortie (17) dont le motif est le même que celui des trous pratiqués dans le matériau isolant,

chaque contact coïncidant avec un trou correspondant et s'étendant depuis la surface de la pastille semi-conductrice jusqu'au conducteur sous-jacent, à travers le film, tandis que le reste de la pastille semi-conductrice est isolée électriquement des conducteurs électriques par le film isolant, relier électriquement les contacts (17) de la pastille aux conducteurs électriques (13) dans les trous et

placer un moyen d'encapsulation autour de la pastille et des conducteurs formés sur le film isolant.

3. Procédé selon la revendication 2, caractérisé en ce que l'étape d'encapsulation comprend le détachement de la partie formant bordure de la pastille encapsulée.


**Ansprüche**

1. Integrierte Schaltungsbaueinheit enthaltend:

   ein Flip-Chip (16) mit hierauf an vorgegebenen Stellen angebrachten, sich vertikal hierzu erstreckenden Ein-/Ausgangsanschlüssen (17),

   eine Anzahl biegsamer, auf einer Isolationsschicht (11) angeordneter Metall-Leiterzüge (13),

   eine Anzahl von Öffnungen in der Isolationsschicht (11), die den Enden der Metall-Leiterzüge (13) gegenüberliegen, so daß die Leiterzüge den Ein-/Ausgangsanschlüssen (17) des Chips ausgesetzt sind,

   wobei die Öffnungen in der Isolation (11) das gleiche Muster aufweisen, wie die Anschlüsse auf dem Chip, so daß die Wirkung einer Fassung vorliegt, um sicherzustellen, daß sowohl das Chip in Bezug auf die Leiterzüge in die richtige Lage gebracht und ausgerichtet ist, als auch die Anschlüsse zwecks elektrischen Kontakts zu den ungeschützten Leiterzügen in die Öffnungen zu liegen kommen, und sich die Länge und Breite der Isolation über alle Kanten des Chips hinaus erstrecken, und

eine das Chip und die Leiterzüge in der Schicht einkapselnde Schutzkappe, dadurch gekennzeichnet, daß die Leiterzüge (13) jeweils in ihrem das Lochmuster in der Isolationsschicht (11) überliegenden Teil eine verringerte Dicke aufweisen.

2. Verfahren zum Herstellen einer integrierten Schaltungs-Baueinheit, enthaltend die Verfahrensschritte:

   Aufbringen elektrischer Leiter (13) auf eine erste Oberfläche einer Schicht (11) aus Isolationsmaterial, indem der mittlere Teil einer Lage aus leitendem Material verdünnt wird, eine Schicht besagten Isolationsmaterials auf die untere Oberfläche der Lage aus leitendem Material aufgebracht wird und die elektrischen Leitungszüge mittels photolithografischer Maßnahmen aus der Lage leitenden Materials unter Beibehalten einer Randleiste (10) bestimmt werden,

   Einbringen einer Anzahl Löcher gemäß einem vorgegebenen Muster in das Isolationsmaterial, wodurch Teile besagter Leiterzüge durch die Löcher freigelegt werden, und

   Aufbringen eines Halbleiter-Chips (16) mit Ein-und Ausgangsanschlüssen (17), deren Anordnungsmuster identisch mit dem der in das Isolationsmaterial auf der Schicht eingebrachten Löcher ist,

   wobei die Anschlüsse sowohl jeweils mit einem entsprechenden Loch lagemäßig zusammenpassen als auch von der Oberfläche des Halbleiter-Chips durch die Schicht hindurch zum jeweils darunterliegenden Leiterzug reichen, während der übrige Teildes Halbleiter-Chips durch die Isolationsschicht von den elektrischen Leiterzügen elektrisch isoliert ist,

   elektrisches Verbinden der Anschlüsse (17) des Chips mit den elektrischen Leiterzügen (13) in den Löchern,

   Einkapseln des Chips und der auf der Isolationsschicht gebildeten Leiterzüge mittels einer Schutzkappe.

3. Verfahren nach Anspruch 2, dadurch gekennzeichnet, daß, der Verfahrensschritt des Einkapselns einschließt:

   Kappen der Randleiste vom eingekapselten Chip.

## FIG. 1

## FIG. 2